**Europäisches Patentamt**

**European Patent Office**

**Office européen des brevets**

(11) Numéro de publication : **0 286 459 B1**

# (12) FASCICULE DE BREVET EUROPEEN

(45) Date de publication du fascicule du brevet :
**29.04.92 Bulletin 92/18**

(51) Int. Cl.$^5$ : **H03H 1/02, H02M 1/14**

(21) Numéro de dépôt : **88400455.7**

(22) Date de dépôt : **29.02.88**

---

(54) **Bloc de filtrage à condensateurs électrochimiques pour convertisseur statique de puissance.**

---

(30) Priorité : **16.03.87 FR 8703712**

(43) Date de publication de la demande :
**12.10.88 Bulletin 88/41**

(45) Mention de la délivrance du brevet :
**29.04.92 Bulletin 92/18**

(84) Etats contractants désignés :
**AT BE CH DE ES GB IT LI NL SE**

(56) Documents cités :
**FR-A- 1 409 260**
**GB-A- 446 559**

(73) Titulaire : **MERLIN GERIN**
**Rue Henri Tarze**
**F-38050 Grenoble Cédex (FR)**

(72) Inventeur : **Fiorina, Jean-Noel**
**Merlin Gerin - Sce Brevets**
**F-38050 Grenoble Cédex (FR)**
Inventeur : **Denis, Hervé**
**Merlin Gerin - Sce Brevets**
**F-38050 Grenoble Cédex (FR)**

(74) Mandataire : **Kern, Paul et al**
**Merlin Gerin Sce. Brevets 20, rue Henri Tarze**
**F-38050 Grenoble Cédex (FR)**

---

## Description

L'invention est relative à un bloc de filtrage pour convertisseur statique de puissance, comprenant une pluralité de condensateurs électrochimiques formés par des bobines à axes parallèles, positionnées sur un support mécanique, et coopérant à l'opposé avec un dispositif de connexion électrique, lesdits condensateurs étant répartis en différents groupes branchés en parallèle aux bornes de l'alimentation, chaque groupe comportant au moins deux condensateurs en série, dont la tension au point milieu est fixée par un diviseur de tension à résistances R d'équilibrage.

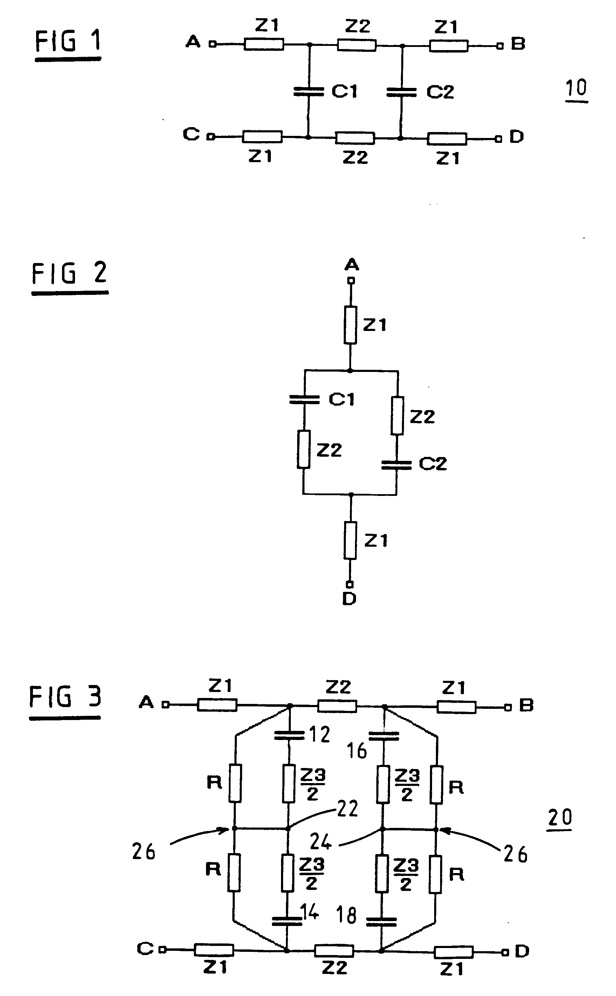

La figure 1 montre le schéma électrique d'une cellule de filtrage 10 de l'art antérieur à deux condensateurs C1 et C2 électrochimiques connectés en parallèle par un dispositif de connexion. Z1 et Z2 représentent les impédances partielles des barres de mise en parallèle du dispositif de connexion. Lorsque la cellule 10 est alimentée entre les points A et D, la répartition des courants ne dépend que des impédances des deux condensateurs C1 et C2, étant donné que chaque condensateur est relié aux polarités opposées de l'alimentation par une impédance de connexion valant 2 Z1 + Z2. Le schéma équivalent entre les points A et D est représenté sur la figure 2. Une telle cellule de filtrage 10 peut convenir pour une alimentation à courant continu dont la tension de service est inférieure à 300 volts.

Pour des alimentations à courant continu ayant des tensions de fonctionnement de valeurs supérieures, par exemple 450 volts continu, il est nécessaire de remplacer chaque condensateur C1 , C2 de la figure 1 par un groupe de deux condensateurs en série, car les condensateurs électrochimiques du commerce présentent généralement une tension nominale de 350V continu. La répartition des tensions continues avec des groupes de condensateurs en série s'effectue d'une manière classique au moyen du schéma de principe de la cellule de filtrage 20 illustrée à la figure 3. La cellule 20 comporte quatre condensateurs 12,14,16,18 répartis en deux groupes de deux, connectés en parallèle aux bornes de l'alimentation. Z1 et Z2 représentent les impédances partielles des barres de connexion pour la mise en parallèle des deux groupes. Le point milieu 22,24 de chaque groupe est connecté à un diviseur de tension 26, à deux résistances R de mêmes valeurs. Chaque condensateur 12 à 18 est branché au point milieu respectif 22,24 par une impédance de connexion Z3/2. Lorsque le courant continu traversant les résistances R est grand par rapport au courant de fuite des condensateurs 12 à 18, chaque diviseur résistif 26 impose la tension au point milieu 22,24 de chaque groupe de manière à équilibrer les tensions continues aux bornes des condensateurs 12,14; 16,18.

Un tel principe de répartition des tensions continues d'une batterie de filtrage est utilisé dans le convertisseur statique ALPES 4000 commercialisé par la demanderesse. Le diviseur de tension à deux résistances est disposé à l'extérieur du bac de logement des condensateurs élémentaires, et est commun pour l'ensemble des groupes de deux condensateurs série. Le point milieu du diviseur résistif est connecté au point milieu respectif de chaque groupe de condensateurs par une liaison électrique individuelle à résistance additionnelle. En fonction de la puissance du convertisseur, chaque bac de la batterie de filtrage comporte un nombre différent de groupes de condensateurs série, et de liaisons câblées individuelles avec le diviseur de tension commun. L'encombrement du bac est spécifique pour chaque puissance, ce qui pose un problème de stockage.

Il en est de même pour le dispositif de connexion à barres de mise en parallèle des condensateurs élémentaires. A chaque puissance de la batterie de filtrage correspond un type donné de dispositif de connexion préfabriqué destiné à raccorder un nombre prédéterminé de condensateurs.

L'objet de l'invention consiste à éviter les inconvénients précités, et à perfectionner la standardisation des batteries de filtrage d'une gamme de convertisseurs de puissance.

La batterie de filtrage selon l'invention est caractérisé en ce que le support mécanique comprend un fond en matériau isolant moulé, ayant un profil de quadrilatère sur lequel sont regroupés quatre condensateurs identiques formant un module standard avec le dispositif de connexion équipé de deux barres à polarités opposées, et que le diviseur de tension comporte:

– une première résistance R d'équilibrage connectée électriquement entre le point milieu du premier groupe de condensateurs, et l'une des barres de polarité positive;

– une deuxième résistance R d'équilibrage de même valeur que la première, et connectée électriquement entre le point milieu du deuxième groupe de condensateurs, et l'autre barre de polarité négative;

– et une impédance Z auxiliaire de connexion insérée électriquement entre les deux points milieux des deux groupes de condensateurs, la valeur de l'impédance Z étant choisie pour que lesdits points milieux se trouvent en parallèle pour le courant continu, mais pas pour le courant alternatif à filtrer.

La valeur de l'impédance Z doit satisfaire à la relation Z3/2<</Z/<<R, de manière à être très petite par rapport à la valeur de la première ou deuxième résistance R, et très grande par rapport à l'impédance de connexion Z3/2 présente entre un point milieu et un condensateur de chaque groupe.

En fonction de la puissance du convertisseur, on utilise un ou plusieurs modules standards pour constituer une batterie de filtrage de capacité prédéterminée. Le support de chaque module comporte avantageusement des moyens d'accouplement pour permettre l'assemblage modulaire des modules entre eux sur les quatre côtés du fond. L'interconnexion électrique entre les différents modules juxtaposés s'opère simplement au moyen de vis de branchement des barres de mêmes polarités.

L'impédance Z auxiliaire de chaque module est constituée par une pièce métallique intermédiaire du dispositif de connexion, ladite pièce étant intercalée entre les deux barres rectilignes de polarités opposées, et présentant un cadre central raccordé par deux pattes de liaison à des barrettes d'extrémités.

Les deux résistances R d'équilibrage de chaque module sont positionnées dans des lyres fixées directement sur la face supérieure du dispositif de connexion.

D'autres avantages et caractéristiques ressortiront plus clairement de la description qui va suivre d'un exemple de réalisation de l'invention, donné à titre d'exemple non limitatif, et représenté aux dessins annexés dans lesquels:

– la figure 4 illustre le schéma électrique d'une cellule de filtrage selon l'invention;

– la figure 5 est une variante de la figure 4;

– la figure 6 est une vue éclatée en perspective d'un module conforme au schéma de la figure 4;

– la figure 7 représente une vue détaillée du dispositif de connexion du module de la figure 6;

– la figure 8 montre diverses associations de modules selon la puissance désirée.

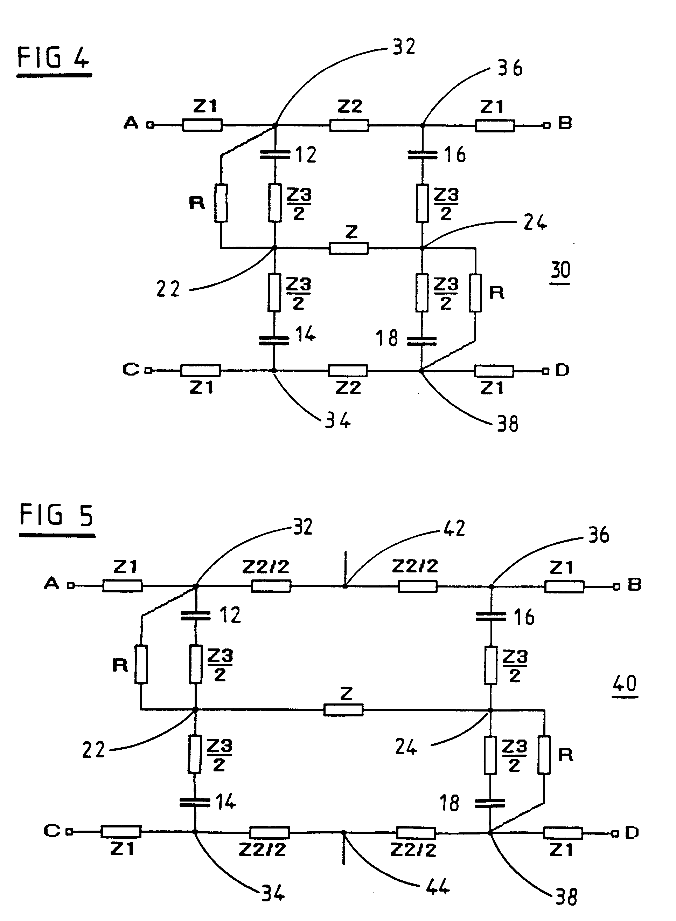

Sur la figure 4, la cellule de filtrage 30 présente une configuration analogue à celle de la figure 3 pour la répartition des condensateurs 12 à 18, et des impédances partielles Z1,Z2,Z3 de connexion. Les mêmes repères sont utilisés pour désigner des éléments identiques. Deux résistances R des diviseurs résistifs 26 ont été supprimées, et une impédance Z auxiliaire de connexion a été insérée électriquement entre les points milieux 22 et 24. Le premier groupe de deux condensateurs 12,14 en série est branché entre les points 32 et 34, tandis que le deuxième groupe de condensateurs 16,18 est connecté entre les points 36,38. Une première résistance R d'équilibrage des tensions aux bornes des condensateurs 12 et 14 est insérée entre les points 32 et 22, et une deuxième résistance R d'équilibrage des tensions aux bornes des condensateurs 16 et 18 est connectée entre les points 24 et 38.

Les impédances partielles Z1 du dispositif de connexion sont agencées entre les points A et 32; 36 et B; C et 34; 38 et D.

Les impédances partielles Z2 se trouvent entre les points de branchement 32 et 36; 34 et 38.

Les impédances partielles Z3/2 se situent entre les points milieux 22,24 et les condensateurs 12 à 18 respectifs.

La valeur de l'impédance Z entre les points milieux 22 et 24 doit satisfaire à la relation (1) :

$$(1) \ |\frac{Z3}{2}| << |Z| << R$$

Il en résulte que les points milieux 22 et 24 ne sont pas en parallèle pour les courants alternatifs à filtrer (première condition $|\frac{Z3}{2}|$ très petit par rapport à $|Z|$), mais le sont pour le courant continu (deuxième condition $|Z|$ très petit par rapport à R). L'alimentation sur la cellule 30 de la fig. 4 s'opère entre les points A et D.

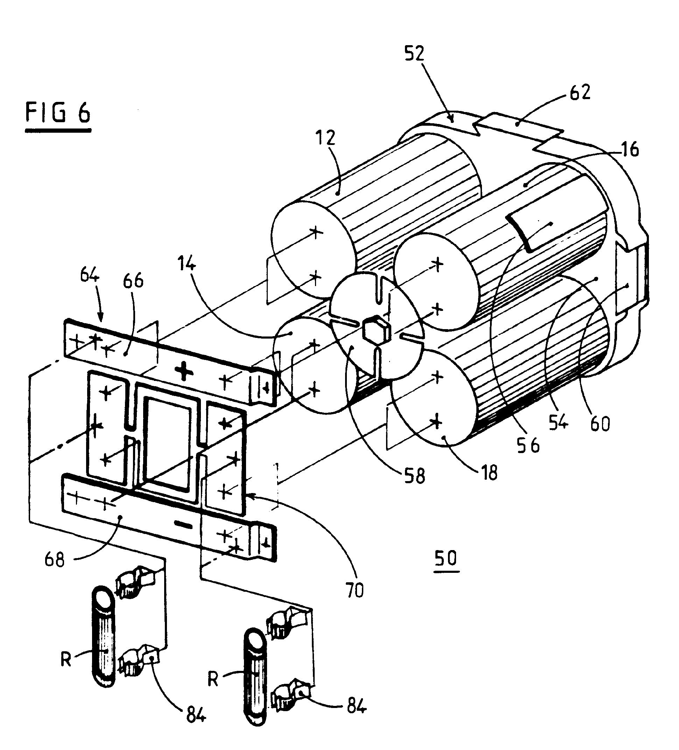

La cellule de filtrage 40 selon la figure 5 est une variante de celle de la figure 4, l'alimentation s'effectuant aux points milieux 42,44 des barres de polarités opposées (milieu de Z2). Les impédances partielles Z2/2 de connexion se trouvent d'une part entre le point supérieur 42 d'alimentation et les points de branchement 32 et 36, et d'autre part entre le point inférieur 44 d'alimentation et les points de branchement 34 et 38. La valeur de l'impédance Z est identique à celle du dispositif de la figure 4, et satisfait à la double condition imposée par la relation (1).

A titre d'exemple, chaque résistance R d'équilibrage de l'une des cellules de filtrage 30 ou 40 possède une valeur voisine de 4700 ohms, alors que le module de l'impédance Z est de l'ordre de quelques milliohms.

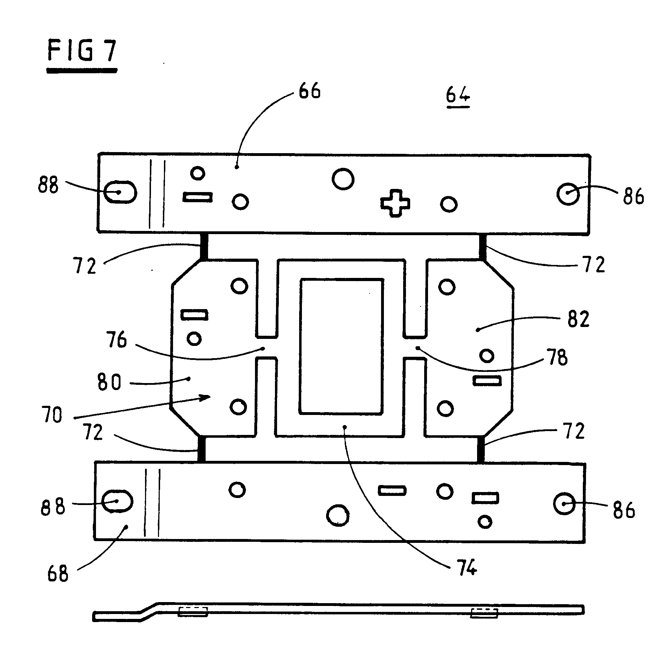

La figure 6 montre le module 50 standard d'une cellule de filtrage à quatre condensateurs 12 à 18 de capacités identiques, dont le schéma électrique correspond à la figure 4. Le module 50 comporte un dispositif de support 52 mécanique, en matériau isolant moulé, ayant un fond 54 en forme de quadrilatère, notamment un carré, sur lequel sont regroupés par quatre, les bobines cylindriques des condensateurs 12 à 18. Le fond 54 est doté d'une pluralité de pattes 56 (une seule est visible sur la figure 6) de positionnement des condensateurs 12 à 18, et un organe 58 de blocage central assure le maintien mécanique des condensateurs sur le fond 54. Les côtés adjacents du fond 54 sont pourvus respectivement d'une rainure 60 en queue d'aronde et d'un tenon 62 de forme conjuguée pour permettre l'association de plusieurs modules 50 identiques entre eux sur les quatre côtés du fond 54. Le dispositif de connexion 64, (figure 6 et 7) des condensateurs 12 à 18 de chaque module 50 présente une configuration standard préfabriquée en aluminium étamé, ayant deux barres 66,68 rectilignes et une pièce intermédiaire 70 de mise en parallèle des deux groupes de condensateurs 12,14; 16,18. La liaison provisoire de la pièce intermédiaire 70 avec les barres 66,68 est assurée par des attaches 72 (figure 7), lesquelles sont ensuite découpées lors du montage du module 50. La barre 66 supérieure de polarité positive correspond au conducteur AB sur le schéma de la figure 4, et la barre 68 inférieure de polarité négative correspond au conducteur CD. L'impédance Z est matérialisée par la forme particulière de la pièce intermédiaire 70 ayant un cadre central 74 raccordé par deux pattes 76,78 de liaison à des barrettes 80,82 d'extrémités. Chaque condensateur 12 à 18 est pourvu d'une paire de bornes de raccordement (voir figure 6) coopérant avec des orifices prédéterminés des barres 66,68 et des barrettes 80,82 du dispositif de connexion 64. Les deux résistances R d'équilibrage sont positionnées dans des lyres 84 fixées directement sur la face supérieure du dispositif de connexion 64 de chaque module 50. Tout câblage par fils indépendants est ainsi évité lors de la préfabrication du module 50.

Chaque barre 66,68 est dotée à ses extrémités opposées d'un trou circulaire 86 et d'un trou oblong 88 autorisant le raccordement avec les dispositifs de connexion des modules adjacents.

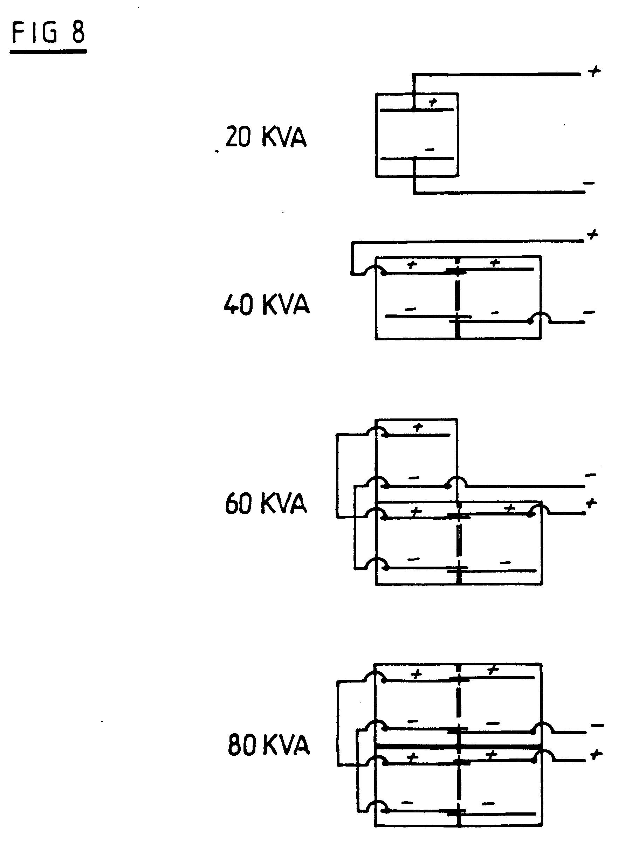

La figure 8 montre l'utilisation d'un ou de plusieurs modules 50 standards selon la figure 6 pour constituer des batteries de filtrage de capacité différente en fonction de la puissance du convertisseur associé.

Pour une puissance de 20 kVA, un seul module 50 avec quatre condensateurs élémentaires 12 à 18 de 2200 microfarads chacun est suffisant, l'alimentation s'effectuant selon le schéma de la figure 5.

Une puissance de 40 kVA, nécessite une association de deux modules 50 identiques s'opérant par assemblage des fonds 54 respectifs sur un même côté, suivi de l'interconnexion des barres 66,68 de mêmes polarités des deux dispositifs de connexion 64 juxtaposés.

Les batteries de filtrage ayant des puissances de 60 kVA et 80 kVA sont formées respectivement par l'association de trois et de quatre modules 50.

Les batteries de filtrage peuvent être intercalées entre un redresseur et un onduleur.

## Revendications

1. Bloc de filtrage pour convertisseur statique de puissance, comprenant une pluralité de condensateurs électrochimiques formés par des bobines à axes parallèles, positionnées sur un support (52) mécanique, et coopérant à l'opposé avec un dispositif de connexion électrique (64), lesdits condensateurs étant répartis en différents groupes branchés en parallèle aux bornes de l'alimentation, chaque groupe comportant au moins, deux condensateurs (12,14; 16,18) en série, dont la tension au point milieu (22,24) est fixée par un diviseur de tension à résistances R d'équilibrage, caractérisé en ce que le support (52) mécanique comprend un fond (54) en matériau isolant moulé, ayant un profil de quadrilatère sur lequel sont regroupés quatre condensateurs (12,14,16,18) identiques formant un module (50) standard avec le dispositif de connexion (64) équipé de deux barres (66,68) à polarités opposées, et que le diviseur de tension comporte :

- une première résistance R d'équilibrage connectée électriquement entre le point milieu (22) du premier groupe de condensateurs (12,14), et l'une (66) des barres de polarité positive;
- une deuxième résistance R d'équilibrage de même valeur que la première, et connectée électriquement entre le point milieu (24) du deuxième groupe de condensateurs (16,18), et l'autre barre (68) de polarité négative;
- et une impédance Z auxiliaire de connexion insérée électriquement entre les deux points milieux (22,24) des deux groupes de condensateurs, la valeur de l'impédance Z étant choisie pour que lesdits points milieux (22,24) se trouvent en parallèle pour le courant continu, mais pas pour le courant alternatif à filtrer.

2. Bloc de filtrage selon la revendication 1 caractérisé en ce que la valeur de l'impédance Z doit satisfaire à la relation /Z3/2/<</Z/<<R, de manière à être très petite par rapport à la valeur de la première ou deuxième résistance R, et très grande par rapport à l'impédance de connexion Z3/2 présente entre un point milieu (22,24) et un condensateur de chaque groupe.

3. Bloc de filtrage selon la revendication 2, caractérisé en ce que l'impédance Z auxiliaire de chaque module est constituée par une pièce métallique intermédiaire (70) du dispositif de connexion (64), ladite pièce étant intercalée entre les deux barres (66,68) rectilignes de polarités opposées, et présentant un cadre (74) central raccordé par deux pattes (76,78) de liaison à des barrettes (80,82) d'extrémités.

4. Bloc de filtrage selon l'une des revendications 1 à 3, caractérisé en ce que les deux résistances R d'équilibrage de chaque module (50) sont positionnées dans des lyres (84) fixées directement sur la face supérieure du dispositif de connexion (64).

5. Bloc de filtrage selon l'une des revendications 1 à 4, caractérisé en ce que le fond (54) du support (52) des quatre condensateurs (12 à 18) de chaque module (50) est doté de moyens d'accouplement (60,62) pour permettre un assemblage modulaire par association de plusieurs modules identiques entre eux sur les quatre côtés du fond (54), et que chaque barre (66,68) rectiligne du dispositif de connexion (64) comporte des trous (86,88) aux extrémités opposées pour le raccordement électrique avec les barres juxtaposées de mêmes polarités des modules voisins.

6. Bloc de filtrage selon l'une des revendications 1 à 5, chaque condensateur ayant la forme d'une bobine cylindrique, caractérisé en ce que le maintien des quatre condensateurs (12 à 18) sur le fond (54) est assuré par un organe de blocage (58) central disposé dans le plan médian du module (50).

7. Bloc de filtrage selon l'une des revendications 1 à 6, caractérisé en ce que le dispositif de connexion (64) à barres est préfabriqué et réalisé en aluminium étamé.

8. Bloc de filtrage selon l'une des revendications 1 à 7, caractérisé en ce que les axes des quatre condensateurs (12 à 18) d'un module (50) sont agencés aux sommets d'un carré.

**Patentansprüche**

1. Filterblock für einen statischen Leistungswandler, welcher eine Mehrzahl von elektrochemischen Kondensatoren aufweist, die von auf einem mechanischen Trägerelement (52) angebrachten Spulen mit parallelen Achsen gebildet sind und die am gegenüberliegenden Ende mit einer Einrichtung für den elektrischen Anschluss (64) zusammenarbeiten, wobei die genannten Kondensatoren in verschiedene, parallel zu den Klemmen des Versorgungsnetzes geschaltete Gruppen aufgeteilt sind, wobei jede Gruppe wenigstens zwei Kondensatoren (12,14; 14,16) in Reihe aufweist, deren Spannung am Mittelpunkt (22,24) durch einen Spannungsteiler mit Abgleichwiderständen R festgesetzt wird, dadurch gekennzeichnet, dass das mechanische Trägerelement (52) eine Bodenfläche (54) aus einem gegossenen Isolierstoff mit einer vier Seiten bildenden Aussenlinie aufweist, auf dem vier identische Kondensatoren (12,14,16,18) gruppiert sind, die mit der mit zwei Schienen (66,68) entgegengesetzter Polaritäten ausgestatteten Anschlusseinrichtung (64) ein Standardmodul (50) bilden, und dass der Spannungsteiler enthält:
  – einen ersten Abgleichwiderstand R, der elektrisch zwischen den Mittelpunkt(22) der ersten Kondensatorengruppe (12,14) und die eine (66), den Pluspol darstellende Schiene geschaltet ist;
  – einen zweiten Abgleichwiderstand R, der den gleichen Wert hat wie der erste und der elektrisch zwischen den Mittelpunkt (24) der zweiten Kondensatorengruppe (16,18) und die andere, den Minuspol darstellende Schiene (68) geschaltet ist;
  – und eine verbindende Hilfsimpedanz Z, die elektrisch zwischen den beiden Mittelpunkten (22,24) der beiden Kondensatorengruppen eingefügt ist, wobei der Wert der Impedanz Z so gewählt ist, dass die genannten Mittelpunkte (22,24) für Gleichstrom parallel liegen, jedoch nicht für den zu filternden Wechselstrom.

2. Filterblock nach Anspruch 1, dadurch gekennzeichnet, dass der Wert der Impedanz Z der Relation /Z3/2/<</Z/<<R entsprechen muss,indem er sehr niedrig ist im Verhältnis zum Wert des ersten oder zweiten Widerstandes R und sehr hoch im Verhältnis zu der zwischen einem Mittelpunkt (22,24) und einem Kondensator jeder Gruppe liegenden Verbindungsimpedanz Z3/2.

3. Filterblock nach Anspruch 2, dadurch gekennzeichnet, dass die Hilfsimpedanz Z jedes Moduls von einem metallischen Zwischenteil (70) der Anschlusseinrichtung (64) gebildet wird, wobei das genannte Teil zwischen den beiden geradlinigen Schienen (66,68) entgegengesetzter Polaritäten eingefügt ist und einen zentralen Rahmen (74) besitzt, der durch zwei Verbindungsstege (76,78) an Endstücke (80,82) gekoppelt ist.

4. Filterblock nach einem der Ansprüche 1 bis 3, dadurch gekennzeichnet, dass die beiden Abgleichwiderstände R jedes Moduls (50) in direkt auf der Oberseite der Anschlusseinrichtung (64) befestigten Klemmschellen (84) angeordnet sind.

5. Filterblock nach einem der Ansprüche 1 bis 4, dadurch gekennzeichnet, dass die Bodenfläche (54) des Trägerelements (52) der vier Kondensatoren (12 bis 18) jedes Moduls (50) mit Kopplungsmitteln (60,62) versehen ist, um durch die Befestigung mehrerer untereinander identischer Module an den vier Seiten der Bodenfläche (54) einen Modulverband zu ermöglichen, und dass jede geradlinige Schiene (66,68) der Anschlusseinrichtung (64) in den sich gegenüberliegenden Enden Löcher (86,88) für die elektrische Ankopplung an die nebenliegenden Schienen gleicher Polarität der Nachbarmodule aufweist.

6. Filterblock nach einem der Ansprüche 1 bis 5, bei dem jeder Kondensator die Form einer Zylinderspule hat, dadurch gekennzeichnet, dass das Festhalten der vier Kondensatoren (12 bis 18) auf der Bodenfläche (54) durch ein in der Mittelebene des Moduls (50) angeordnetes zentrales Verriegelungsorgan übernommen wird.

7. Filterblock nach einem der Ansprüche 1 bis 6, dadurch gekennzeichnet, dass die aus Schienen festgelegte Anschlusseinrichtung (64) vorgefertigt ist und aus verzinntem Aluminium besteht.

8. Filterblock nach einem der Ansprüche 1 bis 7, dadurch gekennzeichnet, dass die Achsen der vier Kondensatoren (12 bis 18) eines Moduls (50) in den Eckpunkten eines Quadrats angeordnet sind.

**Claims**

1. A filter unit for a static power converter, comprising a plurality of electrochemical capacitors formed by coils with parallel axes, positioned on a mechanical support (52), and cooperating at the opposite end with an electrical connecting device (64), said capacitors being divided into different groups connected in parallel to the power supply terminals, each group comprising at least two series-mounted capacitors (12, 14; 16, 18), whose voltage at the mid-point (22, 24) is fixed by a voltage divider with balancing resistors R, characterized in that the mechanical support (52) comprises a base (54) made of moulded insulating material, having a quadrilateral profile on which four identical capacitors (12, 14, 16, 18) are mounted forming a standard module (50) with the connecting device (64) equipped with two bars (66, 68) of opposite polarities, and that the voltage divider comprises :

— a first balancing resistor R electrically connected between the mid-point (22) of the first group of capacitors (12, 14) and one (66) of the bars of positive polarity;

— a second balancing resistor R of the same value as the first, and electrically connected between the mid-point (24) of the second group of capacitors (16, 18) and the other bar (68) of negative polarity;

— and an auxiliary connecting impedance Z electrically inserted between the two mid-points (22, 24) of the two groups of capacitors, the value of the impedance Z being chosen so that said mid-points (22, 24) are in parallel for direct current, but are not for the alternating current to be filtered.

2. The filter unit according to claim 1, characterized in that the value of the impedance Z must satisfy the relationship Z3/2 << /Z/ << R, in such a way as to be very small in relation to the value of the first or second resistor R, and very large in relation to the connecting impedance Z3/2 present between a mid-point (22, 24) and a capacitor of each group.

3. The filter unit according to claim 2, characterized in that the auxiliary impedance Z of each module is formed by an intermediate metal part (70) of the connecting device (64), said part being fitted between the two straight bars (66, 68) of opposite polarities, and presenting a central frame (74) connected by two connecting lugs (76, 78) to small end bars (80, 82).

4. The filter unit according to any one of claims 1 to 3, characterized in that the two balancing resistors R of each module (50) are positioned in clips (84) fixed directly onto the upper face of the connecting device (64).

5. The filter unit according to any one of claims 1 to 4, characterized in that the base (54) of the support (52) of the four capacitors (12 to 18) of each module (50) is provided with coupling means (60, 62) to enable modular assembly by associating several modules identical on the four sides of the base (54), each straight bar (66, 68) of the connecting device (64) comprising holes (86, 88) at the opposite ends for electrical connection with the juxtaposed bars of the same polarities of the adjoining modules.

6. The filter unit according to any one of claims 1 to 5, each capacitor having the shape of a cylindrical coil, characterized in that the four capacitors (12 to 18) are held on the base (54) by a central locking device (58) disposed in the mid-plane of the module (50).

7. The filter unit according to any one of claims 1 to 6, characterized in that the connecting device (64) with bars is prefabricated and made of tin-plated aluminium.

8. The filter unit according to any one of claims 1 to 7, characterized in that the axes of the four capacitors (12 to 18) of a module (50) are arranged at the apexes of a square.

FIG 1

FIG 2

FIG 3

## FIG 4

## FIG 5

FIG 6

## FIG 7

## FIG 8

20 KVA

40 KVA

60 KVA

80 KVA